(19) Europäisches Patentamt
European Patent Office
Office européen des brevets

(11) **EP 2 062 009 B1**

(12) **EUROPÄISCHE PATENTSCHRIFT**

(45) Veröffentlichungstag und Bekanntmachung des Hinweises auf die Patenterteilung:
**11.01.2012   Patentblatt 2012/02**

(21) Anmeldenummer: **07786628.3**

(22) Anmeldetag: **08.08.2007**

(51) Int Cl.:
***G01C 19/56*** *(2012.01)*

(86) Internationale Anmeldenummer:
**PCT/EP2007/007028**

(87) Internationale Veröffentlichungsnummer:
**WO 2008/031480 (20.03.2008 Gazette 2008/12)**

(54) **MIKROELEKTROMECHANISCHER SENSOR SOWIE BETRIEBSVERFAHREN FÜR EINEN MIKROELEKTROMECHANISCHEN SENSOR**

MICROELECTROMECHANICAL SENSOR AND OPERATING METHOD FOR A MICROELECTROMECHANICAL SENSOR

CAPTEUR MICROELECTROMECANIQUE ET PROCEDE DE FONCTIONNEMENT POUR UN CAPTEUR MICROELECTROMECANIQUE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **15.09.2006   DE 102006043412**

(43) Veröffentlichungstag der Anmeldung:
**27.05.2009   Patentblatt 2009/22**

(73) Patentinhaber: **Northrop Grumman LITEF GmbH 79115 Freiburg (DE)**

(72) Erfinder: **SPAHLINGER, Günter 70188 Stuttgart (DE)**

(74) Vertreter: **Müller - Hoffmann & Partner Patentanwälte Innere Wiener Strasse 17 81667 München (DE)**

(56) Entgegenhaltungen:
**WO-A-2004/038331      WO-A-2004/099716**
**DE-A1-102004 056 699      US-B1- 6 250 156**

**Beschreibung**

Die Erfindung betrifft einen mikroelektromechanischen Sensor sowie ein Betriebsverfahren für einen derartigen Sensor.

Mikroelektromechanische Sensoren bilden die Grundlage vieler technischer Produkte. Bewährt haben sich mikroelektromechanische Sensoren beispielsweise auf dem Gebiet der Navigation, wo diese als Corioliskreisel zum Einsatz kommen. Im Folgenden soll die Funktionsweise eines mikroelektromechanischen Sensors beispielhaft anhand eines Corioliskreisels erläutert werden.

Corioliskreisel weisen ein Massensystem auf, das in Schwingungen versetzbar ist. Das Massensystem hat in der Regel eine Vielzahl von Schwingungsmoden, die zunächst voneinander unabhängig sind. Im Betriebszustand des Corioliskreisels (d.h. im Betriebszustand des mikroelektromechanischen Sensors) wird ein bestimmter Schwingungsmode des Massensystems künstlich angeregt, der im Folgenden als "Anregungsschwingung" bezeichnet wird. Wenn der Corioliskreisel gedreht wird, treten Corioliskräfte auf, die der Anregungsschwingung des Massensystems Energie entnehmen und diese auf einen weiteren Schwingungsmode des Massensystems, der im Folgenden als "Ausleseschwingung" bezeichnet wird, übertragen. Um Drehungen des Corioliskreisels zu ermitteln, wird die Ausleseschwingung abgegriffen und ein entsprechendes Auslesesignal daraufhin untersucht, ob Änderungen in der Amplitude der Ausleseschwingung, die ein Maß für die Drehung des Corioliskreisels darstellen, aufgetreten sind. Corioliskreisel können sowohl als Open-Loop-System als auch als Closed-Loop-System realisiert werden. In einem Closed-Loop-System wird über jeweilige Regelkreise die Amplitude der Ausleseschwingung fortlaufend auf einen festen Wert - vorzugsweise Null - rückgestellt, und die Rückstellkräfte gemessen.

Das Massensystem (das im Folgenden auch als "Resonator" bezeichnet wird) des Corioliskreisels (allgemeiner: des mikroelektromechanischen Sensors) kann hierbei unterschiedlichst ausgestaltet sein. Beispielsweise ist es möglich, ein einstückig ausgebildetes Massensystem zu verwenden. Alternativ ist es möglich, das Massensystem in zwei Schwinger aufzuteilen, die miteinander über ein Federsystem gekoppelt sind und Relativbewegungen zueinander ausführen können.

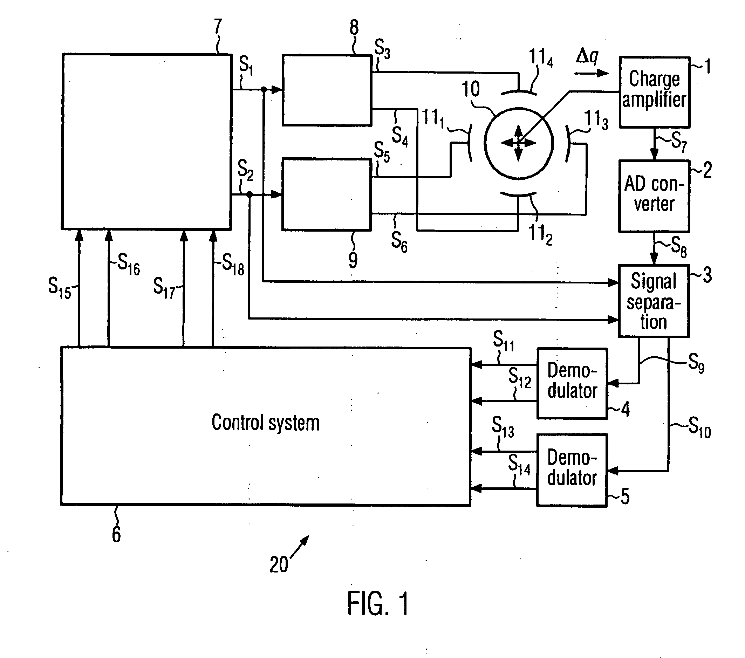

In Fig. 1 ist eine bekannte Ausführungsform eines Corioliskreisels 20 schematisch angedeutet. Der Corioliskreisel 20 weist einen Ladungsverstärker 1, einen Analog-Digital-Wandler 2, eine Signaltrennung 3, Demodulatoren 4, 5, ein Regelsystem 6, einen Modulator 7, Treiber 8, 9, einen Resonator 10 sowie ein Elektrodensystem 11 mit vier Elektroden $11_1$ bis $11_4$ auf.

Der Resonator 10 kann über die Elektroden $11_1$ bis $11_4$ zu Schwingungen angeregt werden. Weiterhin lässt sich über die Elektroden $11_1$ bis $11_4$ die Federkonstante des Resonators 10 elektrostatisch einstellen bzw. ändern. Die Bewegung des Resonators 10 wird durch Messung einer Ladungsverschiebung $\Delta q$ auf einer auf dem Resonator 10 angebrachten Elektrode ("bewegliche Mittelelektrode"), die durch die Bewegung des Resonators 10 innerhalb des durch die Elektroden $11_1$ bis $11_4$ erzeugten elektrostatischen Felds bewirkt wird, ermittelt. Ein der Ladungsverschiebung proportionales Signal $S_7$ wird durch den Ladungsverstärker 1 an den Analog-Digital-Wandler 2 ausgegeben und durch diesen in ein entsprechendes digitales Signal $S_8$ umgewandelt, welches der Signaltrennung 3 zugeführt wird. Aus diesem Signal werden unter Zuhilfenahme der Demodulatoren 4, 5, des Regelsystems 6 sowie des Modulators 7 und der Treiber 8. 9 Signale $S_3$ bis $S_6$ erzeugt, die an die Elektroden $11_1$ bis $11_4$ angelegt werden und dafür sorgen, dass die durch Corioliskräfte bewirkten Auslenkungen des Resonators 10 kompensiert werden. Zur genauen Funktionsweise des Corioliskreisels 20 sei beispielhaft auf die Patentschrift DE 103 20 675 verwiesen.

In der US 6,250,156 B1 wird ein gyroskopischer Sensor für das Messen von Drehungen um eine Z-Achse beschrieben. Dieser umfasst ein Substrat, eine erste und eine zweite Masse, ein Koppelungssystem, das die erste und die zweite Masse miteinander verbindet, ein Verbindungssystem, das die erste und die zweite Masse mit dem Substrat verbindet, und ein Antriebssystem, das die erste und die zweite Masse in Antiphase entlang einer Antriebsachse schwingen lässt.

Die der Erfindung zugrunde liegende Aufgabe ist, einen mikroelektromechanischen Sensor beispielsweise einen kapazitiven Sensor oder einen piezoelektrischen Sensor anzugeben, der trotz geringer Anzahl an Sensorelektroden möglichst weitgehende Funktionalität aufweist.

Zur Lösung dieser Aufgabe stellt die Erfindung einen mikroelektromechanischen Sensor gemäß Patentanspruch 1 bereit. Weiterhin stellt die Erfindung ein Betriebsverfahren für einen mikroelektromechanischen Sensor gemäß Patentanspruch 11 bereit. Bevorzugte Ausgestaltungen bzw. Weiterbildungen des Erfindungsgedankens finden sich in den Unteransprüchen.

Die Erfindung stellt einen mikroelektromechanischen Sensor bereit, mit:

- mindestens einer beweglichen Elektrode;
- einer gegenüber der beweglichen Elektrode beabstandeten Elektroden-anordnung mit mindestens vier separat ansteuerbaren Elektroden, an die entsprechende Elektrodensignale anlegbar sind, wobei mittels der Elektrodensignale die Kraftaufprägung, die Federkonstante und der Auslesefaktor der beweglichen Elektrode elektrostatisch einstellbar/änderbar sind,

- einer mit der Elektrodenanordnung verbundenen Elektrodensignal-Erzeugungseinheit, der ein Kraftaufprägungssignal, ein Federkonstantensignal und ein Auslesefaktorsignal, durch die zu bewirkenden Einstellungen und/oder Änderungen hinsichtlich Kraftaufprägung, Federkonstante und Auslesefaktor der beweglichen Elektrode festgelegt sind, zuführbar sind,
- wobei die Elektrodensignal-Erzeugungseinheit jedes Elektrodensignal in Abhängigkeit des Kraftaufprägungs-, des Federkonstanten- sowie des Auslesefaktorsignals erzeugt und die Elektrodensignale so aufeinander abstimmt, dass die Kraftaufprägung, die Federkonstante sowie der Auslesefaktor der beweglichen Elektrode voneinander unabhängig auf bestimmte Sollwerte einstellbar und/oder änderbar sind.

Eine der Erfindung zugrunde liegende wesentliche Erkenntnis ist, dass sich die Elektrodensignale für jede beliebige Elektrodenanordnung so aufeinander abstimmen lassen, dass die Kraftaufprägung, die Federkonstante sowie der Auslesefaktor der beweglichen Elektrode voneinander unabhängig auf bestimmte Sollwerte einstellbar/änderbar sind, womit eine maximale Flexibilität des Betriebsverfahrens des mikroelektromechanischen Sensors gegeben ist. "Beliebige Elektrodenanordnung" bedeutet in diesem Zusammenhang eine beliebige räumliche Anordnung aus mindestens drei Elektroden.

Wie bereits erwähnt, kann das Massensystem (das im Folgenden auch als "Resonator" bezeichnet wird) des mikroelektromechanischen Sensors unterschiedlichst ausgestaltet sein. Beispielsweise ist es möglich, ein einstückig ausgebildetes Massensystem zu verwenden. Alternativ ist es möglich, das Massensystem in zwei Schwinger aufzuteilen, die miteinander über ein Federsystem gekoppelt sind und Relativbewegungen zueinander ausführen können.

In einer Ausführungsform ist der erfindungsgemäße Sensor mit einer Ladungsverschiebeeinheit versehen, die auf der beweglichen Elektrode auftretende Ladungsverschiebungen detektiert, wobei mittels einer Auswerteeinheit, basierend auf der detektierten Ladungsverschiebung, die momentane Bewegung der beweglichen Elektrode ermittelt werden kann.

In einer Ausführungsform erzeugt die Elektrodensignal-Erzeugungseinheit jedes Elektrodensignal in Abhängigkeit des Kraftaufprägungs-, des Federkonstanten- sowie des Auslesefaktorsignals derart, dass die auf der beweglichen Elektrode detektierte Ladungsverschiebung nur Ladungsverschiebungs-Anteile enthält, die von der Bewegung der beweglichen Elektrode und von dem Wert des Auslesefaktors herrühren, der Auslesefaktor ist dabei zu interpretieren als Verstärkungsfaktor zum Auslesen der Bewegung der beweglichen Elektrode.

Die Elektrodenanordnung kann aus einer geraden oder ungeraden Anzahl an Elektroden bestehen. Des Weiteren können die Ausmaße beziehungsweise Ausgestaltungen der einzelnen Elektroden untereinander differieren. In einer bevorzugten Ausführungsform enthält die Elektrodenanordnung vier (vorzugsweise identische) Elektroden, die beispielsweise in zwei Elektrodenpaare gruppiert sein können, wobei die Elektroden achsensymmetrisch bezüglich einer ersten Achse, die die beiden Elektrodenpaare voneinander trennt, und achsensymmetrisch bezüglich einer zweiten Achse, die die Elektroden der jeweiligen Elektrodenpaare untereinander trennt, ausgestaltet sind. Vorteilhafterweise ist die bewegliche Elektrode punktsymmetrisch bezüglich des Schnittpunkts der beiden Symmetrieachsen ausgestaltet.

In einer Ausführungsform, in der die bewegliche Elektrode als Teil eines Resonators ausgebildet ist, lässt sich die bewegliche Elektrode zu Schwingungen anregen und der Sensor kann beispielsweise als Corioliskreisel benutzt werden.

In einer Ausführungsform mit zwei beweglichen Elektroden, zwei Elektrodenanordnungen und zwei Elektrodensignal-Erzeugungseinheiten lassen sich beide beweglichen Elektroden getrennt voneinander durch entsprechende Wahl der beiden Auslesefaktoren auslesen und die Bewegungen (beeinflusst über die Kraftaufprägung) und Federkonstanten unabhängig voneinander einstellen.

Die Erfindung stellt weiterhin ein Betriebsverfahren für einen mikroelektromechanischen Sensor bereit, der eine bewegliche Elektrode sowie eine gegenüber, der beweglichen Elektrode beabstandete Elektrodenanordnung mit mindestens vier separat ansteuerbaren Elektroden, an die entsprechende Elektrodensignale anlegbar sind, aufweist, mit den folgenden Schritten:

- Erzeugen der Elektrodensignale in Abhängigkeit eines Kraftaufprägungssignals, ein Federkonstantensignals und ein Auslesefaktorsignals, durch die zu bewirkenden Einstellungen und/oder Änderungen hinsichtlich Bewegung, Federkonstante und Auslesefaktor der beweglichen Elektrode festgelegt sind,

- Anlegen der Elektrodensignale an die entsprechenden Elektroden, um die Kraftaufprägung, die Federkonstante und den Auslesefaktor der beweglichen Elektrode elektrostatisch einzustellen und/oder zu ändern,

- wobei jedes Elektrodensignal in Abhängigkeit des Kraftaufprägungs-, des Federkonstanten- sowie des Auslesefaktorsignals erzeugt und die Elektrodensignale so aufeinander abgestimmt werden, dass die Kraftaufprägung, die Federkonstante sowie der Auslesefaktor der beweglichen Elektrode voneinander unabhängig auf bestimmte Sollwerte eingestellt und/oder geändert werden.

Die Erfindung wird im Folgenden unter Bezugnahme auf die Figuren in beispielsweiser Ausführungsform näher erläutert. Es zeigen:

Fig. 1 eine Prinzipskizze eines bekannten mikroelektromechanischen Sensors (Coriollskreisel),

Fig. 2 eine Ausführungsform eines erfindungsgemäßen mikroelektromechanischen Sensors mit einer beweglichen Elektrode.

Fig. 3a eine weitere Ausführungsform eines erfindungsgemäßen mikroelektronischen Sensors mit zwei beweglichen Elektroden.

Fig. 3b einen schematischen Zeitverlauf für das Anlegen zweier Auslesefaktoren.

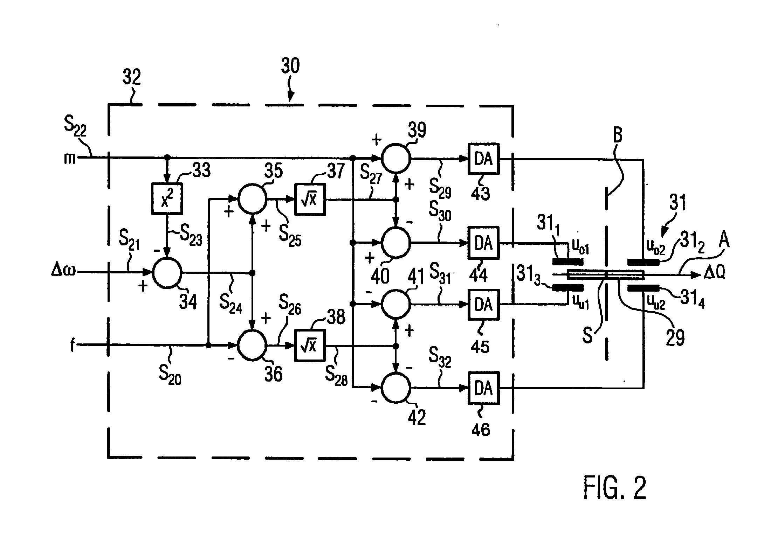

Fig. 2 zeigt einen Ausschnitt einer bevorzugten Ausführungsform des erfindungsgemäßen mikroelektromechanischen Sensors 30. Der in Fig. 2 gezeigte Ausschnitt kann in etwa mit dem "Ensemble" Modulator 7, Treiber 8, 9, Resonator 10 sowie Elektrodenanordnung $11_1$ bis $11_4$ und in Fig. 1 verglichen werden.

Fig. 2 zeigt eine gegenüber einer beweglichen Elektrode 29, die beispielsweise Teil eines (nicht gezeigten) Resonators sein kann, beabstandete Elektrodenanordnung 31, bestehend aus einer ersten bis vierten Elektrode $31_1$ bis $31_4$. Die erste und dritte Elektrode $31_1$, $31_3$ sowie die zweite und vierte Elektrode $31_2$, $31_4$ bilden jeweils ein Elek-trodenpaar. Die Elektroden eines Elektrodenpaars sind achsensymmetrisch bezüglich einer Achse A angeordnet. Des Weiteren sind die Elektrodenpaare voneinander durch eine senkrecht auf der Achse A stehende Achse B achsensymmetrisch voneinander getrennt. Die bewegliche Elektrode 29 ist beispielsweise punktsymmetrisch bezüglich eines Schnittpunkts S der beiden Symmetrieachsen A. B ausgestaltet, wie in Fig. 2 gezeigt.

Zu sehen ist weiterhin eine Elektrodensignal-Erzeugungseinheit 32, der ein Kraftaufprägungssignal $S_{20}$ (auch als "f" bezeichnet), ein Federkonstantensignal $S_{21}$ (auch als "$\Delta\omega$" bezeichnet) sowie ein Auslesefaktorsignal $S_{22}$ (auch als "m" bezeichnet) zuführbar sind. Das Auslesefaktorsignal $S_{22}$ wird in einer Quadriereinheit 33 quadriert und das so erhaltene Signal $S_{23}$ mit negativem Vorzeichen einer ersten Addierstufe 34 zugeführt, wo dieses auf das Federkonstan-tensignal $S_{21}$ addiert wird. Das Ausgangssignal $S_{24}$ der Addierstufe 34 wird einer zweiten und einer dritten Addierstufe 35, 36 zugeführt. In der zweiten Addierstufe 35 wird das Signal $S_{24}$ auf das Signal $S_{20}$ addiert, wohingegen in der dritten Addierstufe 36 das Signal $S_{20}$ mit negativem Vorzeichen auf das Signal $S_{24}$ addiert wird. Die Ausgangssignale $S_{25}$, $S_{26}$ der Addierstufen 35, 36 werden Wurzeleinheiten 37, 38 zugeführt, die jeweils aus einem der Signale $S_{25}$, $S_{26}$ die Wurzel ermitteln. Die Ausgangssignale $S_{27}$, $S_{28}$ der Wurzeleinheiten 37, 38 werden einer vierten bis siebten Addierstufe 39 bis 42 zugeführt, durch die jedes der Signale $S_{27}$, $S_{28}$ jeweils einmal auf das Signal $S_{22}$ addiert und von diesem Signal abgezogen werden. Entsprechende Ausgangssignale $S_{29}$ bis $S_{32}$ werden Digital-Analog-Wandlern 43 bis 46 zugeführt, die die (bislang digitalen) Signale in Analogsignale $u_{o1}$, $u_{o2}$, $u_{u1}$, $u_{u2}$ umwandeln und an die entsprechenden Elektroden $31_1$ bis $31_4$ anlegen. Die Signale $u_{o1}$, $u_{o2}$, $u_{u1}$ und $u_{u2}$ stellen die Elektrodensignale im Sinne der Erfindung dar und können in Abhängigkeit des Kraftaufprägungssignals $S_{20}$ (=f), des Federkonstantensignals $S_{21}$ (=$\Delta\omega$) sowie des Aus-lesefaktorsignals $S_{22}$ (=m) wie folgt ausgedrückt werden:

$$u_{o1} = \sqrt{\Delta\omega - m^2 + f} + m \qquad (1)$$

$$u_{o2} = -\sqrt{\Delta\omega - m^2 + f} + m \qquad (2)$$

$$u_{u1} = \sqrt{\Delta\omega - m^2 - f} - m \qquad (3)$$

$$u_{u2} = -\sqrt{\Delta\omega - m^2 - f} - m \qquad (4)$$

Dementsprechend stellen die Elektrodensignale $u_{o1}.u_{o2}$ diejenigen Elektrodensignale dar, die an den oberhalb der Achse A befindlichen Elektroden $31_1$. $31_2$ anliegen, und $u_{u1}$, $u_{u2}$ die Elektrodensignale dar, die an den unterhalb der Achse A befindlichen Elektroden $31_3$, $31_4$ anliegen. Der Anschluss der beweglichen Elektrode 29 liegt auf virtueller Masse, gemessen wird die aus der beweglichen Elektrode, 29 herausfließende Ladung.

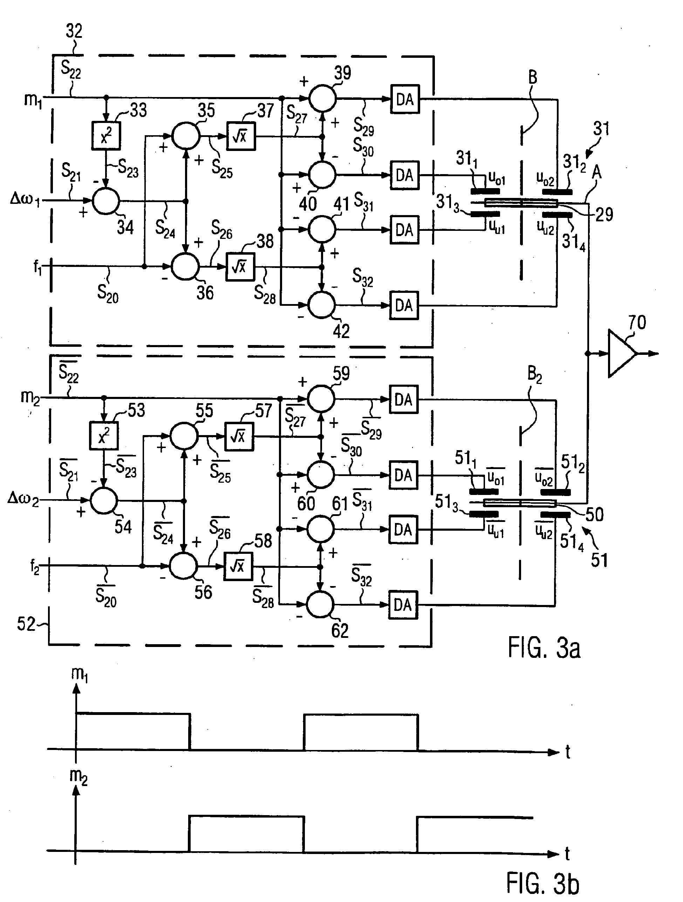

In Fig. 3 ist gezeigt, wie zwei bewegliche, elektrisch verbundene Elektroden 29, 50 im Multiplexverfahren kombiniert werden können. Die Steuersignale m, und $m_2$, geschaltet wie in Fig. 3b dargestellt, machen abwechselnd jeweils eine bewegliche Elektrode 29, 50 für den Ladungsverstärker 70 sichtbar. Unabhängig davon können die Krafteinprägungen $f_1$ und $f_2$ sowie die Abstimmungen $\Delta\omega_1$ und $\Delta\omega_2$ gewählt werden.

Fig. 3 zeigt eine gegenüber einer zweiten beweglichen Elektrode 50, die mit der mindestens einen beweglichen Elektrode 29 elektrisch verbunden ist, beabstandete Elektrodenanordnung 51, bestehend aus einer ersten bis vierten Elektrode $51_1$ bis $51_4$. Die erste und dritte Elektrode $51_1$, $51_9$ sowie die zweite und vierte Elektrode $51_2$, $51_4$ bilden jeweils ein Elektrodenpaar. Die Elektroden eines Elektrodenpaars sind achsensymmetrisch bezüglich einer Achse $A_2$ angeordnet. Des Weiteren sind die Elektrodenpaare voneinander durch eine senkrecht auf der Achse $A_2$ stehenden Achse $D_2$ achsensymmetrisch voneinander getrennt.

Zu sehen ist weiterhin eine zweite Elektrodensignal-Erzeugungseinheit 52, der ein zweites Kraftaufprägungssignal $\overline{S_{20}}$ (auch als "$f_2$" bezeichnet), ein zweites Federkonstantensignal $\overline{S_{21}}$ (auch als "$\Delta\omega_2$" bezeichnet) sowie ein zweites Auslesefaktorsignal $\overline{S_{22}}$ (auch als "$m_2$" bezeichnet) zuführbar sind. Das zweite Auslesefaktorsignal $\overline{S_{22}}$ wird in einer zweiten Quadriereinheit 53 quadriert und das so erhaltene Signal $\overline{S_{23}}$ mit negativem Vorzeichen einer achten Addierstufe 54 zugeführt, wo dieses auf das zweite Federkonstantensignal $\overline{S_{21}}$ addiert wird. Das Ausgangssignal $\overline{S_{24}}$ der achten Addierstufe 54 wird einer neunten und einer zehnten Addierstufe 55, 56 zugeführt. In der neunten Addierstufe 55 wird das Signal $\overline{S_{24}}$ auf das Signal $\overline{S_{20}}$ addiert, wohingegen in der zehnten Addierstufe 56 das Signal $\overline{S_{20}}$ mit negativem Vorzeichen auf das Signal $\overline{S_{24}}$ addiert wird. Die Ausgangssignale $\overline{S_{25}}$, $\overline{S_{26}}$ der Addierstufen 55, 56 werden zweiten Wurzeleinheiten 57, 58 zugeführt, die jeweils aus einem der Signale $\overline{S_{25}}$, $\overline{S_{26}}$ die Wurzel ermitteln. Die Ausgangssignale $\overline{S_{27}}$, $\overline{S_{28}}$ der zweiten Wurzeleinheiten 57, 58 werden einer elften bis vierzehnten Addierstufe 59 bis 62 zugeführt, durch die jedes der Signale $\overline{S_{27}}$, $\overline{S_{28}}$ jeweils einmal auf das Signal $\overline{S_{22}}$ addiert und von diesem Signal abgezogen werden. Entsprechende Ausgangssignale $\overline{S_{29}}$ bis $\overline{S_{32}}$ werden zweiten Digital-Analog-Wandlern 63 bis 66 zugeführt, die die (bislang digitalen) Signale in Analogsignale $\overline{u_{o1}}$, $\overline{u_{o2}}$, $\overline{u_{u1}}$, $\overline{u_{u2}}$ umwandeln und an die entsprechenden Elektroden $51_1$ bis $51_4$ anlegen. Die Signale $\overline{u_{o1}}$, $\overline{u_{o2}}$, $\overline{u_{u1}}$, und $\overline{u_{u2}}$ stellen die Elektrodensignale im Sinne der Erfindung dar und können in Abhängigkeit des zweiten Kraftaufprägungssignals $\overline{S_{20}}$, des zweiten Federkonstantensignals $\overline{S_{21}}$ sowie des zweiten Auslesefaktorsignals $\overline{S_{22}}$ wie folgt ausgedrückt werden:

$$\overline{u_{o1}} = \sqrt{\Delta\omega_2 - m_2^2 + f_2} + m_2 \qquad (5)$$

$$\overline{u_{o2}} = -\sqrt{\Delta\omega_2 - m_2^2 + f_2} + m_2 \qquad (6)$$

$$\overline{u_{u1}} = \sqrt{\Delta\omega_2 - m_2^2 - f_2} - m_2 \qquad (7)$$

$$\overline{u_{u2}} = -\sqrt{\Delta\omega_2 - m_2^2 - f_2} - m_2 \qquad (8)$$

Dementsprechend stellen die Elektrodensignale $\overline{u_{o1}}$, $\overline{u_{o2}}$ diejenigen Elektrodensignale dar, die an den oberhalb der Achse $A_2$ befindlichen Elektroden $51_1$, $51_2$ anliegen, und $\overline{u_{u1}}$, $\overline{u_{u2}}$ die Elektrodensignale dar, die an den unterhalb

der Achse $A_2$ befindlichen Elektroden $51_3$, $51_4$ anliegen.

In der folgenden Beschreibung sollen weitere Aspekte der Erfindung erläutert werden.

Es ist vorteilhaft, wenn im Betrieb von (kapazitiven) mikroelektromechanischen Sensoren zur Messung von Beschleunigung oder Drehrate folgende Forderungen erfüllt werden können:

1. Auf eine bewegliche Elektrode soll eine definierte elektrostatisch erzeugte Kraft ausgeübt werden können (Torquer-Funktion).

2. Auf dieselbe bewegliche Elektrode soll eine definierte elektrostatisch erzeugte Federkraft angelegt werden können. Die Federkonstante ist in der Regel negativ und soll eine positive mechanische Feder in einem vorgegebenen Maß "weicher" machen, um damit eine definierte Abstimmung der Eigenresonanz eines mechanischen Schwingers zu ermöglichen.

3. Die Auslenkung der Elektrode soll über einen einstellbaren Auslesefaktor messbar gemacht werden (Pickoff-Funktion) können.

4. Es soll möglich sein, dass während des Betriebs keine weiteren als von der Auslenkung und dem Auslesefaktor abhängigen Komponenten im Messsignal enthalten sind.

Es sei ein Kondensator mit einer beweglichen Elektrode gegeben. Die Elektrode kann an einem Betätigungspunkt um eine Auslenkung x bewegt werden. Die Kapazität ist dann von x abhängig: $C = C(x)$. Aus dem Energiesatz folgt, dass bei einer am Kondensator angelegten Spannung U am Betätigungspunkt eine elektrostatische Kraft

$$F = \frac{U^2}{2}\frac{dC}{dx} \tag{9}$$

wirksam wird. Beim Differentialkondensator handelte es sich um zwei Kondensatoren mit gemeinsamem Betätigungspunkt, wobei

$$C_1(x) = C_2(-x) \tag{10}$$

gilt. Es sei nun näherungsweise:

$$C_1(x) = C_0(1 + \alpha_1 x + \alpha_2 x^2) \tag{11}$$

und damit

$$C_2(x) = C_0(1 - \alpha_1 x + \alpha_2 x^2) \tag{12}$$

Liegen nun an den Kondensatoren die Spannungen $U_1$ und $U_2$ an, so wird die Kraft am Betätigungspunkt der beweglichen Elektrode:

$$F = \frac{U_1^2}{2}\frac{dC_1}{dx} + \frac{U_2^2}{2}\frac{dC_2}{dx} \tag{13}$$

Setzt man (11) und (12) ein, so wird:

$$F = (U_1^2 - U_2^2)\alpha_1 C_0 + 2x(U_1^2 + U_2^2)\alpha_2 C_0 \tag{14}$$

Somit setzt sich die Kraft aus einem von x unabhängigen Teil und einem zu x proportionalem Anteil, der einer Federkonstante entspricht, zusammen. Der von x unabhängige Teil ist zu $U_1^2 - U_2^2$ proportional, die Federkonstante ist zu $U_1^2 + U_2^2$ proportional.

Entsprechend gilt bei 4 Kondensatoren mit

$$C_{o1}(x) = C_{o2}(x) = C_0(1 + \alpha_1 x + \alpha_2 x^2) \qquad (15)$$

$$C_{u1}(x) = C_{u2}(x) = C_0(1 - \alpha_1 x + \alpha_2 x^2) \qquad (16)$$

für die Kraft:

$$F = (U_{o1}^2 + U_{o2}^2 - U_{u1}^2 - U_{u2}^2)\alpha_1 C_0 + 2x(U_{o1}^2 + U_{o2}^2 + U_{u1}^2 + U_{u2}^2)\alpha_2 C_0$$

$$(17)$$

Hier ist also der wegunabhängige Term proportional zu

$$U_{o1}^2 + U_{o2}^2 - U_{u1}^2 - U_{u2}^2 \qquad (18)$$

und die Federkonstante zu

$$U_{o1}^2 + U_{o2}^2 + U_{u1}^2 + U_{u2}^2 \qquad (19)$$

Der wegunabhängige Teil eignet sich zur Einprägung einer gewünschten Kraft (Rückstellung, Torquer), und die Federkonstante ermöglicht im Zusammenspiel mit einem Feder-Masse-System die Abstimmung desselben auf eine gewünschte Resonanzfrequenz.

Für die Ladungen gilt:

$$Q = C_{o1}U_{o1} + C_{o2}U_{o2} + C_{u1}U_{u1} + C_{u2}U_{u2} \qquad (20)$$

Setzt man nun (15) und (16) ein, so wird unter Vernachlässigung des quadratischen Terms:

$$Q = 2C_0(U_{o1} + U_{o2} + U_{u1} + U_{u2}) \qquad (21)$$

$$+ 2C_0(U_{o1} + U_{o2} - U_{u1} - U_{u2})\alpha_1 x \qquad (22)$$

Der erste Term erzeugt ein von x unabhängiges Durchsprechen (und ist in der Regel unerwünscht), während der zweite Teil zu x proportional ist, und daher zur Auslesung der Auslenkung x geeignet ist. Berücksichtigt man den quadratischen Term, so wird

$$Q = 2C_0(U_{o1} + U_{o2} + U_{u1} + U_{u2})(1 + \alpha_2 x^2) \qquad (23)$$

$$+ 2C_0(U_{o1} + U_{o2} - U_{u1} - U_{u2})\alpha_1 x \qquad (24)$$

und man sieht, dass dieser zusammen mit dem konstanten Term (wenn man das Durchsprechen zu Null macht, also für $U_{o1} + U_{o2} + U_{u1} + U_{u2} = 0$) verschwindet.

Die Forderungen 1.) - 3.) können mit dem erfindungsgemäßen Sensor und dem erfindungsgemäßen Betriebsverfahren unabhängig voneinander erfüllt sein. Es kann also sowohl eine Kraft aufgeprägt werden , ohne dass ein Auslesesignal erzeugt wird, wie auch umgekehrt für einen von Null verschiedenen Auslesefaktor keine aufgeprägte Kraft die notwendige Folge sein muss.

Für allgemeine Elektrodenanordnungen lassen sich analoge Gleichungssysteme aufstellen, wenn folgende Regeln berücksichtigt werden:

Die auf allen Elektroden befindlichen Ladungen sind stets so groß, dass es

1) in Summe am Ladungsverstärker-Eingang keine von der Auslenkung x unabhängigen Terme gibt.
2) in Summe am Ladungsverstärker-Eingang einen von der Auslenkung x abhängigen Teil mit einstellbarem Verstärkungsfaktor gibt,
3) eine einstellbare Kraftwirkung unabhängig von der Auslenkung x auf die bewegliche Elektrode gibt,
4) ein in ihrer Federkonstanten einstellbare elektrostatische Feder an der beweglichen Elektrode gibt.

Über den einstellbaren Auslesefaktor lässt sich z.B. ein "heruntermischender Detektor" realisieren, wenn beispielsweise der Auslesefaktor als sinusförmiger Träger mit derselben Frequenz wie die Elektrodenschwingung ausgestaltet ist. Dabei wird die Schwingung auf die Frequenz 0 heruntergemischt, was zu einem phasenempfindlichen Demodulator führt. Weiterhin lassen sich über den einstellbaren Auslesefaktor die Auslesefunktionen mehrerer Schwinger, deren bewegliche Elektroden elektrisch verbunden sind, im Zeitmultiplexverfahren auslesen, indem immer nur der Auslesefaktor eines Schwingers auf einen von Null verschiedenen Wert gesetzt wird, und demnach in zeitlicher Abfolge immer nur eine Schwingerbewegung durch den gemeinsamen Ladungsverstärker detektiert wird. Die auf einer Kapazitätsmessung beruhende Auslesefunktion

$$Q(\Delta x) = U(C_0 + \frac{\partial C}{\partial x} \Delta x) \qquad (25)$$

führt in aller Regel dazu, dass bei einem Einschalten des Auslesefaktors über die Spannung U nicht nur einen von der Auslenkung $\Delta x$ abhängige Komponente auftritt, sondern zudem gleichzeitig ein beträchtlich größerer, von der Ruhekapazität $C_0$ abhängiger Anteil. Das erfindungsgemäße Verfahren unterdrückt diesen unerwünschten Anteil, wie im folgenden anhand der Nomenklatur der Figur 2 gezeigt wird.

Die auf die bewegliche Elektrode 29 wirkende Kraft ist nach G1. (18) ist proportional zu

$$u_{o1}^2 + u_{o2}^2 - u_{u1}^2 - u_{u2}^2 = 4f \qquad (26)$$

Damit ist die Forderung 1 erfüllt. Die Verstimmung aufgrund einer elektrostatischen Feder ist nach G1. (19) proportional zu

$$u_{o1}^2 + u_{o2}^2 + u_{u1}^2 + u_{u2}^2 = 4\Delta\omega \qquad (27)$$

Damit ist die Forderung 2 erfüllt. Der Auslesefaktor ist nach G1. (21) proportional zu

$$u_{o1} + u_{o2} - u_{u1} - u_{u2} = 4m \qquad (28)$$

Damit ist die 3. Forderung erfüllt. Ferner ist nach G1. (22)

$$u_{o1} + u_{o2} + u_{u1} + u_{u2} = 0 \qquad (29)$$

womit schließlich die 4. Forderung erfüllt ist. Für eine korrekte Funktion muss die Dimensionierung so vorgenommen werden, dass stets

$$|f| < \Delta\omega - m^2 \qquad (30)$$

ist.

Erfindungsgemäß wird demnach ein Betriebsverfahren für mikroelektromechanische Sensoren (MEMS-Sensoren) mit geteilten Elektroden beschrieben. Das erfindungsgemäße Verfahren erlaubt es, bei Systemen mit mehreren elektrisch gekoppelten beweglichen Elektroden Anregungskraft. Resonanzabstimmung und Auslesefaktor getrennt voneinander einzustellen. Damit ist ein Auslesevorgang im Multiplexbetrieb völlig unabhängig von Anregungsprozessen (Erzeugung der Anregungsschwingung) und Abstimmungsprozessen (z. B. Frequenzabstimmung von Anregungsschwingung auf Ausleseschwingung, um einen doppelresonanten Resonator zu erhalten) möglich.

**Patentansprüche**

1. Mikroelektromechanischer Sensor (30), mit:

   - mindestens einer beweglichen Elektrode (29),
   - einer gegenüber der beweglichen Elektrode (29) beabstandeten Elektrodenanordnung ($31_1$ - $31_4$) mit mindestens vier separat ansteuerbaren Elektroden, an die entsprechende Elektrodensignale ($u_{o1}$, $u_{o2}$, $U_{u1}$, $u_{u2}$) anlegbar sind, wobei mittels der Elektrodensignale die Kraftaufprägung, die Federkonstante und der Auslesefaktor des Resonators elektrostatisch einstellbar/änderbar sind,
   - eine mit der Elektrodenanordnung ($31_1$ - $31_4$) verbundenen Elektrodensignal-Erzeugungseinheit (32), der ein Kraftaufprägungssignal (f), ein Federkonstantensignal ($\Delta\omega$) und ein Auslesefaktorsignal (m) durch die zu bewirkenden Einstellungen/Änderungen hinsichtlich Kraftaufprägung, Federkonstante und Auslesefaktor der beweglichen Elektrode (29) festgelegt sind, zuführbar sind,
   - wobei die Elektrodensignal-Erzeugungseinheit (32) dafür eingerichtet ist, jedes Elektrodensignal ($u_{o1}$, $u_{o2}$, $u_{u1}$, $u_{u2}$) in Abhängigkeit des Kraftaufprängungs-, des Federkonstantensowie des Auslesefaktorsignals (f, $\Delta\omega$, m) zu erzeugen und die Elektrodensignale ($u_{o1}$, $u_{o2}$, $u_{u1}$, $u_{u2}$) so aufeinander abzustimmen dass die Kraftaufprägung, die Federkonstante sowie der Auslesefaktor des Resonators voneinander unabhängig auf bestimmte Sollwerte einstellbar/änderbar sind.

2. Mikroelektromechanischer Sensor (30) nach Anspruch 1,
   **gekennzeichnet durch**

   - eine Ladungsverschiebeeinheit, die dafür eingerichtet ist, die auf der beweglichen Elektrode (29) auftretende Ladungsverschiebungen zu detektieren und
   - eine Auswerteeinheit, die dafür eingerichtet ist, basieren auf der detektierten Ladungsverschiebung die momentane Bewegung der beweglichen Elektrode (29) zu ermitteln.

3. Mikroelektromechanischer Sensor (30) nach Anspruch 2,
   **dadurch gekennzeichnet,**
   **dass** die Elektrodensignal-Erzeugungseinheit dafür eingerichtet ist, jedes Elektrodensignal ($u_{o1}$, $u_{o2}$, $u_{u1}$, $u_{u2}$) in Abhängigkeit des Kraftaufprägungs- des Federkonstanten- sowie des Auslesefaktorsignals (f, $\Delta\omega$, m) so zu erzeugen, dass die Ladungsverschiebung nur Ladungsverschiebungs-Anteile enthält, die von der Bewegung der beweglichen Elektrode (29) und von dem Wert des Auslesefaktors herrühren.

**4.** Mikroelektromechanischer Sensor (30) nach einem der vorstehenden Ansprüche,
    **dadurch gekennzeichnet,**
    **dass** die Elektrodenanordnung ($31_1$ - $31_4$) vier Elektroden enthält.

**5.** Mikroelektromechanischer Sensor (30) nach Anspruch 4,
    **dadurch gekennzeichnet,**
    **dass** die vier Elektroden ($31_1$ - $31_4$) in zwei Elektrodenpaare ($31_1$, $31_3$; $31_2$, $31_4$) gruppiert sind, wobei die Elektroden achsensymmetrisch bezüglich einer ersten Achse (B), die die beiden Elektrodenpaare ($31_1$, $31_3$; $31_2$, $31_4$) voneinander trennt, und achsensymmetrisch bezüglich einer zweiten Achse (A), die die Elektroden der jeweiligen Elektrodenpaare ($31_1$, $31_3$; $31_2$, $31_4$) untereinander trennt, ausgestaltet sind.

**6.** Mikroelektromechanischer Sensor (30) nach Anspruch 5,
    **dadurch gekennzeichnet,**
    **dass** die bewegliche Elektrode (29) punktsymmetrisch bezüglich des Schnittpunkts (S) der beiden Symmetrieachsen (A, B) ausgestaltet ist.

**7.** Mikroelektromechanischer Sensor (30) nach Anspruch 5,
    **dadurch gekennzeichnet ,**
    **dass** die Elektrodensignale ($u_{o1}$, $u_{o2}$, $u_{u1}$, $u_{u2}$) durch die folgenden Gleichungen gegeben sind:

$$u_{o1} = \sqrt{\Delta\omega - m^2 + f} + m$$

$$u_{o2} = -\sqrt{\Delta\omega - m^2 + f} + m$$

$$u_{u1} = \sqrt{\Delta\omega - m^2 - f} - m$$

$$u_{u2} = -\sqrt{\Delta\omega - m^2 - f} - m$$

wobei
($\Delta\omega$) der Wert des Federkonstantensignals, (m) der Wert des Auslesefaktorsignals, und (f) der Wert des Kraftaufprägungssignals. ($u_{o1}$, $u_{o2}$) die Werte der Elektrodensignale, die oberhalb der zweiten Achse liegen, und ($u_{u1}$, $u_{u2}$) die Werte der Elektrodensignale, die unterhalb der zweiten Achse liegen, darstellen.

**8.** Mikroelektromechanischer Sensor (30) nach Anspruch 7,
    **dadurch gekennzeichnet,**
    **dass** die folgende Relation gilt:

$$|f| < \Delta\omega - m^2$$

**9.** Mikroelektromechanischer Sensor (30) nach einem der Ansprüche 1 bis 8,
    **dadurch gekennzeichnet,**
    **dass** die bewegliche Elektrode (29) als Teil eines Resonators ausgebildet ist.

**10.** Mikroelektromechanischer Sensor (30) nach einem der Ansprüche 1 bis 9, **gekennzeichnet durch** eine zweite bewegliche Elektrode (50), die mit der mindestens einen beweglichen Elektrode (29) elektrisch verbunden ist,

- eine gegenüber der zweiten beweglichen Elektrode (50) beabstandeten zweiten Elektrodenanordnung ($51_1$ - $51_4$) mit weiteren mehreren separat ansteuerbaren Elektroden, an die entsprechende Elektrodensignale ($\overline{u_{o1}}$, $\overline{u_{o2}}$, $\overline{u_{u1}}$, $\overline{u_{u2}}$) anlegbar sind, wobei mittels der Elektrodensignale die Kraftaufprägung, die Federkonstante und der Auslesefaktor der zweiten beweglichen Elektrode (50) elektrostatisch einstellbar/änderbar sind,

- eine mit der zweiten Elektrodenanordnung ($51_1$ - $51_4$) verbundenen zweiten Elektrodensignal-Erzeugungseinheit (52), der ein zweites Kraftaufprägungssignal ($f_2$), ein zweites Federkonstantensignal ($\Delta\omega_2$) und ein zweites Auslesefaktorsignal ($m_2$) durch die zu bewirkenden Einstellungen/Änderungen hinsichtlich Kraftaufprägung. Federkonstante und Auslesefaktor des Resonators festgelegt sind, zuführbar sind,

- wobei die zweite Elektrodensignal-Erzeugungseinheit (52) dafür eingerichtet ist, jedes Elektrodensignal ($\overline{u_{o1}}$, $\overline{u_{o2}}$ $\overline{u_{u1}}$, $\overline{u_{u2}}$) in Abhängigkeit des zweiten Kraftaufprägungs-, des zweiten Federkonstanten- sowie des zweiten Auslesefaktorsignals ($f_2$, $\Delta\omega_2$, $m_2$) zu erzeugen und die Elektrodensignale ($u_{o1}$, $u_{o2}$, $u_{u1}$, $u_{u2}$) so aufeinander abzustimmen, dass die zweite Kraftaufprägung, die zweite Federkonstante sowie der zweite Auslesefaktor der zweiten beweglichen Elektrode (50) voneinander unabhängig sowie unabhängig von der Kraftaufprägung, der Federkonstante sowie dem Auslesefaktor der mindestens einen beweglichen Elektrode (29) auf bestimmte Sollwerte einstellbar/änderbar sind.

**11.** Betriebsverfahren für einen mikroelektromechanischen Sensor (30), der mindestens eine bewegliche Elektrode (29) sowie eine gegenüber der beweglichen Elektrode (29) beabstandete Elektrodenanordnung ($31_1$ - $31_4$) mit mindestens vier separat ansteuerbaren Elektroden, an die entsprechende Elektrodensignale ($u_{o1}$, $u_{o2}$, $u_{u1}$, $u_{u2}$) anlegbar sind, aufweist, mit den folgenden Schritten:

- Erzeugen der Elektrodensignale ($u_{o1}$, $u_{o2}$, $u_{u1}$, $u_{u2}$) in Abhängigkeit eines Kraftaufprägungssignals ($f$), eines Federkonstantensignals ($\Delta\omega$) und eines Auslesefaktorsignals ($m$), durch die zu bewirkenden Einstellungen/Änderungen hinsichtlich Kraftaufprägung, Federkonstante und Auslesefaktor der beweglichen Elektrode (29) festgelegt sind,

- Anlegen der Elektrodensignale ($u_{o1}$, $u_{o2}$, $u_{u1}$, $u_{u2}$) an die entsprechenden Elektroden, um die Kraftaufprägung, die Federkonstante und den Auslesefaktor der beweglichen Elektrode (29) elektrostatisch einzustellen/zu ändern,

- wobei jedes Elektrodensignal ($u_{o1}$), $u_{o2}$, $u_{u1}$, $u_{u2}$) in Abhängigkeit des Kraftaufprägungs- ($f$), des Federkonstanten- ($\Delta\omega$) sowie des Auslesefaktorsignals ($m$) erzeugt und die Elektrodensignale so aufeinander abgestimmt werden, dass die Kraftaufprägung, die Federkonstante sowie der Auslesefaktor der beweglichen Elektrode (29) voneinander unabhängig auf bestimmte Sollwerte eingestellt/geändert werden.

**Claims**

**1.** A microelectromechanical sensor (30), comprising:

- at least one movable electrode (29),
- an electrode arrangement ($31_1$ - $31_4$) spaced apart from the movable electrode (29) and having at least four electrodes which can be driven separately and to which corresponding electrode signals ($u_{o1}$, $u_{o2}$, $u_{u1}$, $u_{u2}$) can be applied, wherein the electrode signals can be used to electrostatically set/change the application of force, the spring constant and the read-out factor of the resonator,
- an electrode signal generation unit (32), which is connected to the electrode arrangement ($31_1$ - $31_4$) and can be supplied with a force application signal ($f$), a spring constant signal ($\Delta\omega$) and a read-out factor signal ($m$), which define the settings/changes to be brought about with regard to the application of force, spring constant and read-out factor of the movable electrode (29),
- wherein the electrode signal generation unit (32) is adapted to generate each electrode signal ($u_{o1}$, $u_{o2}$, $u_{u1}$, $u_{u2}$) in a manner dependent on the force application signal, the spring constant signal and the read-out factor signal ($f$, $\Delta\omega$, $m$) and to match the electrode signals ($u_{o1}$, $u_{o2}$, $u_{u1}$, $u_{u2}$) to one another in such a way that the application of force, the spring constant and the read-out factor of the resonator can be set/changed to specific desired values independently of one another.

**2.** The microelectromechanical sensor (30) as claimed in claim 1, **characterized by**

- a charge transfer unit adapted to detect charge transfers occurring on the movable electrode (29), and
- an evaluation unit adapted to determine the instantaneous movement of the movable electrode (29) on the basis of the detected charge transfer.

3. The microelectromechanical sensor (30) as claimed in claim 2,
**characterized**
**in that** the electrode signal generation unit is adapted to generate each electrode signal ($u_{o1}$, $u_{o2}$, $u_{u1}$, $u_{u2}$) in a manner dependent on the force application signal, the spring constant signal and the read-out factor signal (f, $\Delta\omega$, m) in such a way that the charge transfer only contains charge transfer components which originate from the movement of the movable electrode (29) and from the value of the read-out factor.

4. The microelectromechanical sensor (30) as claimed in any of the preceding claims,
**characterized**
**in that** the electrode arrangement ($31_1$ - $31_4$) contains four electrodes.

5. The microelectromechanical sensor (30) as claimed in claim 4,
**characterized**
**in that** the four electrodes ($31_1$ - $31_4$) are grouped into two electrode pairs ($31_1$, $31_3$; $31_2$, $31_4$), wherein the electrodes are configured axially symmetrically with respect to a first axis (B), which separates the two electrode pairs ($31_1$, $31_3$; $31_2$, $31_4$) from one another, and axially symmetrically with respect to a second axis (A), which separates the electrodes of the respective electrode pairs ($31_1$, $31_3$; $31_2$, $31_4$) among one another.

6. The microelectromechanical sensor (30) as claimed in claim 5,
**characterized**
**in that** the movable electrode (29) is configured centrosymmetrically with respect to the point of intersection (S) of the two axes of symmetry (A, B).

7. The microelectromechanical sensor (30) as claimed in claim 5,
**characterized**
**in that** the electrode signals ($u_{o1}$, $u_{o2}$, $u_{u1}$, $u_{u2}$) are given by the following equations:

$$u_{o1} = \sqrt{\Delta\omega - m^2 + f} + m$$

$$u_{o2} = -\sqrt{\Delta\omega - m^2 + f} + m$$

$$u_{u1} = \sqrt{\Delta\omega - m^2 - f} - m$$

$$u_{u2} = -\sqrt{\Delta\omega - m^2 - f} - m$$

where
($\Delta\omega$) represents the value of the spring constant signal, (m) represents the value of the read-out factor signal, and (f) represents the value of the force application signal, ($u_{o1}$, $u_{o2}$) represent the values of the electrode signals lying above the second axis, and ($u_{u1}$, $u_{u2}$) represent the values of the electrode signals lying below the second axis.

8. The microelectromechanical sensor (30) as claimed in claim 7,
**characterized**

**in that** the following relation holds true:

$$\left| f \right| < \Delta\omega - m^2$$

9. The microelectromechanical sensor (30) as claimed in any of claims 1 to 8.
**characterized**
**in that** the movable electrode (29) is embodied as part of a resonator.

10. The microelectromechanical sensor (30) as claimed in any of claims 1 to 9, **characterized by** a second movable electrode (50), which is electrically connected to the at least one movable electrode (29),

   - a second electrode arrangement ($51_1$ - $51_4$) spaced apart from the second movable electrode (50) and having a further plurality of electrodes which can be driven separately and to which corresponding electrode signals ($\overline{u_{o1}}$, $\overline{u_{o2}}$, $\overline{u_{u1}}$, $\overline{u_{u2}}$) can be applied, wherein the electrode signals can be used to electrostatically set/change the application of force, the spring constant and the read-out factor of the second movable electrode (50),
   - a second electrode signal generation unit (52), which is connected to the second electrode arrangement ($51_1$ - $51_4$) and can be supplied with a second force application signal ($f_2$), a second spring constant signal ($\Delta\omega_2$) and a second read-out factor signal ($m_2$), which define the settings/changes to be brought about with regard to the application of force, spring constant and read-out factor of the resonator,
   - wherein the second electrode signal generation unit (52) is adapted to generate each electrode signal ($\overline{u_{o1}}$, $\overline{u_{o2}}$, $\overline{u_{u1}}$, $\overline{u_{u2}}$) in a manner dependent on the second force application signal, the second spring constant signal and the second read-out factor signal ($f_2$, $\Delta\omega_2$, $m_2$) and to match the electrode signals ($u_{o1}$, $u_{o2}$, $u_{u1}$, $u_{u2}$) to one another in such a way that the second application of force, the second spring constant and the second read-out factor of the second movable electrode (50) can be set/changed to specific desired values independently of one another and independently of the application of force, the spring constant and the read-out factor of the at least one movable electrode (29).

11. An operating method for a microelectromechanical sensor (30) having at least one movable electrode (29) and an electrode arrangement ($31_1$ - $31_4$) spaced apart from the movable electrode (29) and having at least four electrodes which can be driven separately and to which corresponding electrode signals ($u_{o1}$, $u_{o2}$, $u_{u1}$, $u_{u2}$) can be applied, comprising the following steps:

   - generation of the electrode signals ($u_{o1}$, $u_{o2}$, $u_{u1}$, $u_{u2}$) in a manner dependent on a force application signal (f), a spring constant signal ($\Delta\omega$) and a read-out factor signal (m), which define the settings/changes to be effected with regard to the application of force, spring constant and read-out factor of the movable electrode (29),
   - application of the electrode signals ($u_{o1}$, $u_{o2}$, $u_{u1}$, $u_{u2}$) to the corresponding electrodes in order to electrostatically set/change the application of force, the spring constant and the read-out factor of the movable electrode (29),
   - wherein each electrode signal ($u_{o1}$, $u_{o2}$, $u_{u1}$, $u_{u2}$) is generated in a manner dependent on the force application signal (f), the spring constant signal ($\Delta\omega$) and the read-out factor signal (m) and the electrode signals are matched to one another in such a way that the application of force, the spring constant and the read-out factor of the movable electrode (29) are set/changed to specific desired values independently of one another.

**Revendications**

1. Capteur microélectromécanique (30), avec :

   - au moins une électrode mobile (29),
   - un dispositif à électrodes ($31_1$-$31_4$), espacé de l'électrode mobile (29), avec au moins quatre électrodes qui sont aptes à être commandées séparément et auxquelles des signaux d'électrodes correspondants ($u_{o1}$, $u_{o2}$, $u_{u1}$, $u_{u2}$) peuvent être appliqués, étant précisé qu'à l'aide des signaux d'électrodes, l'application de force, la constante de rappel et le facteur de sélection du résonateur peuvent être réglés/modifiés par voie électrostatique,
   - une unité génératrice de signaux d'électrodes (32) qui est reliée au dispositif à électrodes ($31_1$-$31_4$) et à laquelle peuvent être transmis un signal d'application de force (f), un signal de constante de rappel ($\Delta\omega$) et un signal de facteur de sélection (m) grâce auxquels les réglages/modifications à effectuer en matière d'application de force, de constante de rappel et de facteur de sélection - de l'électrode mobile (29) sont fixés,
- étant précisé que l'unité génératrice de signaux d'électrodes (32) est conçue pour générer chaque signal d'électrode ($u_{o1}$, $u_{o2}$, $u_{u1}$, $u_{u2}$) en fonction des signaux d'application de force, de constante de rappel et de facteur de sélection (f, $\Delta\omega$, m) et pour accorder les signaux d'électrodes ($u_{o1}$, $u_{o2}$, $u_{u1}$, $u_{u2}$) de telle sorte que l'application de force, la constante de rappel et le facteur de sélection du résonateur puissent être réglés/modifiés indépendamment les uns des autres sur des valeurs théoriques.

2. Capteur microélectromécanique (30) selon la revendication 1, **caractérisé par**

   - une unité de transfert de charge qui est conçue pour détecter les transferts de charge apparaissant sur l'électrode mobile (29), et
   - une unité d'analyse qui est conçue pour rechercher, sur la base du transfert de charge détecté, le déplacement momentané de l'électrode mobile (29).

3. Capteur microélectromécanique (30) selon la revendication 2, **caractérisé en ce que** l'unité génératrice de signaux d'électrodes est conçue pour générer chaque signal d'électrode ($u_{o1}$, $u_{o2}$, $u_{u1}$, $u_{u2}$) en fonction des signaux d'application de force, de constante de rappel et de facteur de sélection (f, $\Delta\omega$, m) de telle sorte que le transfert de charge ne contienne que des parts de transfert de charge qui proviennent du déplacement de l'électrode mobile (29) et de la valeur du facteur de sélection.

4. Capteur microélectromécanique (30) selon l'une des revendications précédentes, **caractérisé en ce que** le dispositif à électrodes ($31_1$-$31_4$) contient quatre électrodes.

5. Capteur microélectromécanique (30) selon la revendication 4, **caractérisé en ce que** les quatre électrodes ($31_1$-$31_4$) sont groupées en deux paires d'électrodes ($31_1$, $31_3$ ; $31_2$, $31_4$), étant précisé que les électrodes sont conçues avec une symétrie axiale par rapport à un premier axe (B) qui sépare les deux paires d'électrodes ($31_1$, $31_3$ ; $31_2$, $31_4$) , et avec une symétrie axiale par rapport à un second axe (A) qui sépare les électrodes des paires d'électrodes ($31_1$, $31_3$ ; $31_2$, $31_4$).

6. Capteur microélectromécanique (30) selon la revendication 5, **caractérisé en ce que** l'électrode mobile (29) est conçue avec une symétrie ponctuelle par rapport à l'intersection (S) des deux axes de symétrie (A, B).

7. Capteur microélectromécanique (30) selon la revendication 5, **caractérisé en ce que** les signaux d'électrodes ($u_{o1}$, $u_{o2}$, $u_{u1}$, $u_{u2}$) sont définis par les équations suivantes :

$$u_{o1} = \sqrt{\Delta\omega - m^2 + f} + m$$

$$u_{o2} = -\sqrt{\Delta\omega - m^2 + f} + m$$

$$u_{u1} = \sqrt{\Delta\omega - m^2 - f} - m$$

$$u_{u2} = -\sqrt{\Delta\omega - m^2 - f} - m$$

étant précisé que ($\Delta\omega$) représente la valeur du signal de constante de rappel, (m) la valeur du signal de facteur de sélection, et (f) la valeur du signal d'application de force, ($u_{o1}$, $u_{o2}$) les valeurs des signaux d'électrodes qui sont situées au-dessus du second axe, et ($u_{u1}$, $u_{u2}$) les valeurs des signaux d'électrodes qui sont situées au-dessus du second axe.

8. Capteur microélectromécanique (30) selon la revendication 7, **caractérisé en ce qu'**on a la relation suivante :

$$\left| f \right| < \Delta\omega - m^2 .$$

**9.** Capteur microélectromécanique (30) selon l'une des revendications 1 à 8, **caractérisé en ce que** l'électrode mobile (29) est conçue comme une partie d'un résonateur.

**10.** Capteur microélectromécanique (30) selon l'une des revendications 1 à 9, **caractérisé par** une seconde électrode mobile (50), qui est reliée électriquement à ladite électrode mobile (29),

- un second dispositif à électrodes ($51_1$-$51_4$), espacé de la seconde électrode mobile (50), avec plusieurs autres électrodes qui sont aptes à être commandées séparément et auxquelles des signaux d'électrodes correspondants ($\overline{u_{o1}}, \overline{u_{o2}}, \overline{u_{u1}}, \overline{u_{u2}}$) peuvent être appliqués, étant précisé qu'à l'aide des signaux d'électrodes, l'application de force, la constante de rappel et le facteur de sélection de la seconde électrode mobile (50) peuvent être réglés/modifiés par voie électrostatique,
- une seconde unité génératrice de signaux d'électrodes (52) qui est reliée au second dispositif à électrodes ($51_1$-$51_4$) et à laquelle peuvent être transmis un second signal d'application de force ($f_2$), un second signal de constante de rappel ($\Delta\omega_2$) et un second signal de facteur de sélection ($m_2$) grâce auxquels les réglages/modifications à effectuer en matière d'application de force, de constante de rappel et de facteur de sélection du résonateur sont fixés,
- étant précisé que la seconde unité génératrice de signaux d'électrodes (52) est conçue pour générer chaque signal d'électrode ($\overline{u_{o1}}, \overline{u_{o2}}, \overline{u_{u1}}, \overline{u_{u2}}$) en fonction des seconds signaux d'application de force, de constante de rappel et de facteur de sélection ($f_2$, $\Delta\omega_2$, $m_2$) et pour accorder les signaux d'électrodes ($u_{o1}$, $u_{o2}$, $u_{u1}$, $u_{u2}$) de telle sorte que la seconde application de force, la seconde constante de rappel et le second facteur de sélection de la seconde électrode mobile (50) puissent être réglés/modifiés indépendamment les uns des autres et indépendamment de l'application de force, de la constante de rappel et du facteur de sélection de ladite électrode mobile (29) sur des valeurs théoriques définies.

**11.** Procédé de fonctionnement pour un capteur microélectromécanique (30) qui comporte au moins une électrode mobile (29) et un dispositif à électrodes ($31_1$-$31_4$), espacé de l'électrode mobile (29), avec au moins quatre électrodes qui sont aptes à être commandées séparément et auxquelles des signaux d'électrodes ($u_{o1}$, $u_{o2}$, $u_{u1}$, $u_{u2}$) peuvent être appliqués, avec les étapes suivantes :

- production des signaux d'électrodes ($u_{o1}$, $u_{o2}$, $u_{u1}$, $u_{u2}$) en fonction d'un signal d'application de force (f), d'un signal de constante de rappel ($\Delta\omega$) et d'un signal de facteur de sélection (m) grâce auxquels les réglages/modifications à effectuer en matière d'application de force, de constante de rappel et de facteur de sélection de l'électrode mobile (29) sont fixés,
- application des signaux d'électrodes ($u_{o1}$, $u_{o2}$, $u_{u1}$, $u_{u2}$) aux électrodes correspondantes, afin de régler/modifier par voie électrostatique l'application de force, la constante de rappel et le facteur de sélection de l'électrode mobile (29),
- étant précisé que chaque signal d'électrode ($u_{o1}$, $u_{o2}$, $u_{u1}$, $u_{u2}$) est généré en fonction du signal d'application de force (f), de constante de rappel ($\Delta\omega$) et de sélection (m) et que les signaux d'électrodes sont accordés de telle sorte que l'application de force, la constante de rappel et le facteur de sélection de l'électrode mobile (29) soient réglés/modifiés indépendamment les uns des autres sur des valeurs théoriques définies.

FIG. 1

FIG. 2

EP 2 062 009 B1

FIG. 3a

FIG. 3b

18

**IN DER BESCHREIBUNG AUFGEFÜHRTE DOKUMENTE**

**In der Beschreibung aufgeführte Patentdokumente**

- DE 10320675
- US 6250156 B1